# FASCICULE DE BREVET EUROPEEN

(11) **EP 1 384 267 B1**
(45) Date de publication et mention de la délivrance du brevet: **18.01.2012**
(21) Numéro de dépôt: 02706836.0
(22) Date de dépôt: 11.02.2002
(51) Int. Cl.: H01L 27/06, H01L 27/08, H01L 27/088

(54) **DISPOSITIF D'AJUSTEMENT DES CIRCUITS AVANT MISE EN BOITIER**
ANORDNUNG ZUR EINSTELLUNG VON SCHALTKREISEN VOR DEREN EINBAU
DEVICE FOR ADJUSTING CIRCUITS BEFORE ENCAPSULATION

(30) Priorité: 12.02.2001 FR 0101872
(43) Date de publication de la demande: 28.01.2004
(73) Titulaire: STMicroelectronics S.A., 92120 Montrouge (FR)
(72) Inventeur: LAVILLE, Sébastien, F-38100 Grenoble (FR); PONTAROLLO, Serge, F-38950 Saint-Martin Le Vinoux (FR)
(74) Mandataire: Casalonga, Axel
(86) Numéro de dépôt international: PCT/FR2002/000503
(87) Numéro de publication internationale: WO 2002/065551

(56) Documents cités:
- EP-A- 0 718 887
- DE-A- 2 435 606
- FR-A- 2 124 142
- US-A- 4 016 483
- US-A- 5 936 288
- US-A- 6 040 608

## Description

La présente invention concerne le domaine des circuits intégrés analogiques et numériques. Ces circuits doivent utiliser une surface de silicium la plus faible possible afin de réduire les coûts tout en conservant une forte précision.

Une plaquette de silicium à l'issue des différentes étapes de gravure et/où de dépôt de couches conductrices, semi conductrices ou isolantes fait l'objet d'une étape de tri destinée à éliminer les circuits présentant des défauts. Après l'étape de tri, on met en oeuvre une étape de mise en boîtier ou encapsulation.

Lors de l'étape de tri, on effectue des tests sur chaque circuit d'une plaquette afin de vérifier leur conformité à un cahier des charges. Le circuit peut être considéré comme satisfaisant, à mettre au rebut ou encore à ajuster. L'ajustement est effectué en imposant des tensions et/ou des courants électriques déterminés à des plots du circuit intégré, certains plots pouvant ne plus être accessibles après l'encapsulation du circuit. Un circuit intégré avec un réseau d'impédances programmables est décrit dans US 4016483. US 6040608 décrit un dispositif programmable comprenant une plulalité de transistors MOS.

La présente invention propose un dispositif permuttant l'ajustement d'un circuit intégré avant l'encapsulation lors de l'étape de tri.

La présente invention propose un dispositif faisant partie d'un circuit intégré et disposé entre un plot de contact extérieur accessible même après encapsulation et le reste du circuit c'est-à-dire sa partie utile destinée à réaliser une fonction particulière.

Le circuit électronique intégré, selon un aspect de l'invention, comprend une pluralité de transistors MOS. Le circuit comprend au moins un premier et un deuxième transistors MOS disposés en série, chaque transistor comprenant une grille et une source court-circuitées, et une base reliée à la masse du circuit intégré, caractérisé par le fait qu'il comprend une première résistance montée parallèlement au premier transistor et une deuxième résistance montée parallèlement au deuxième transistor.

Dans un mode de réalisation de l'invention, le circuit comprend un troisième transistor monté en série avec le premier et le deuxième transistors, et comprenant une grille et une source court-circuitées, et une jonction de base reliée à la masse du circuit intégré.

Le circuit peut comprendre une troisième résistance montée parallèlement au troisième transistor. En effet, c'est la masse globale du circuit qui est nécessaire pour le bon fonctionnement du circuit.

Dans un mode de réalisation de l'invention, le circuit comprend un plot de connexion relié à la source du premier transistor et accessible après l'encapsulation du circuit. Alternativement, une résistance peut être montée entre le plot et la source du premier transistor.

Dans un mode de réalisation de l'invention, le circuit comprend un plot de connexion relié à la source du deuxième transistor et non accessible après l'encapsulation du circuit et un plot de connexion relié au drain du deuxième transistor et non accessible après l'encapsulation du circuit.

Dans un mode de réalisation de l'invention, le circuit comprend en outre un plot de connexion relié au drain du troisième transistor et non accessible après l'encapsulation du circuit. Plus généralement, le plot de connexion relié au drain du énième transistor peut être relié au reste du circuit. On entend par transistor MOS disposé en série, les transistors dont la source du n+1^{ième} transistor est connectée au drain du n^{ième} transistor.

Les transistors MOS peuvent être de type isolé ou de type non isolé. De préférence, la prise de base sera adjacente au drain.

L'invention propose également un procédé d'ajustement de résistance électrique dans un circuit électronique intégré comprenant une pluralité de transistors MOS montés en série et chacun pourvu d'une résistance montée en parallèle. On relie les bases des transistors MOS. On applique à un transistor MOS une première tension sur sa base, sa grille et sa source et une deuxième tension sur son drain afin de claquer le dit transistor MOS.

De préférence, on relie les bases des transistors MOS à la masse globale du circuit et on court-circuite la base des transistors à la grille et à la source du transistor MOS à casser.

De préférence, la première tension est constante et la deuxième tension est une rampe monotone. La première tension peut être nulle et la deuxième tension peut être croissante.

Le claquage du transistor MOS peut être effectué par avalanche de la jonction drain/substrat, claquage irréversible de la jonction drain/ substrat et court-circuit entre le drain et la source. La différence entre les première et deuxième tension est d'environ 16 V. Le courant de claquage peut être inférieur à 100 mA.

L'invention s'applique aussi bien au transistor MOS-N qu'au transistor MOS-P.

L'utilisation de transistors MOS dit "snap-back" permet d'obtenir un court circuit et donc d'obtenir une résistance à l'intérieur d'un circuit intégré en agissant sur les broches du circuit intégré auquel on peut accéder avant l'encapsulation. Le composant ainsi réalisé occupe une faible place sur une plaquette de silicium et est donc bon marché. Le fait que la grille et la source du transistor MOS soient court-circuités garantit le blocage permanent dudit transistor MOS et évite qu'il n'influe sur le fonctionnement du reste du circuit électronique. Avant claquage, le transistor MOS peut être assimilé à un circuit ouvert.

L'invention met à profit une caractéristique naturelle des transistors MOS qui est de posséder des composants parasites, en particulier un transistor bi-polaire. Dans certaines configurations, ces composants parasites sont néfastes. Lors de décharges électrostatiques, des circuits peuvent être gravement endommagés par mise en conduction du transistor parasite.

A l'inverse, l'invention utilise le transistor bipolaire parasite du transistor MOS pour en faire un court circuit et obtenir une résistance de valeur prédéterminée entre le drain et la source du transistor MOS, c'est-à-dire entre le collecteur et l'émetteur du transistor bi-polaire parasite. Ce composant peut être considéré comme un "anti-fusible". En effet, un fusible est un circuit fermé à l'état normal et un circuit ouvert après claquage. Ici, le transistor MOS est un circuit ouvert avant claquage et un circuit fermé après claquage avec une faible valeur de résistance résiduelle.

La présente invention sera mieux comprise à l'étude de la description détaillée de quelques modes de réalisation pris à titre d'exemple nullement limitatifs illustrés par les dessins annexés, sur lesquels :
la figure 1 est une courbe caractéristique de fonctionnement d'un transistor MOS;
la figure 2 est une vue en coupe transversale d'un transistor MOS ;
la figure 3 est un schéma du dispositif selon l'invention; et

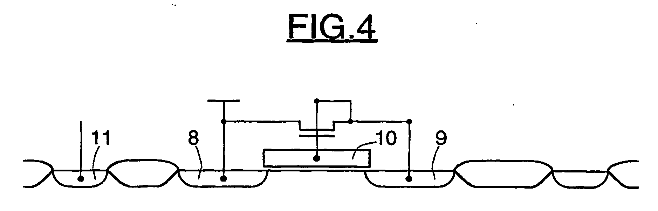

la figure 4 est une vue en coupe transversale d'une variante de transistor MOS.

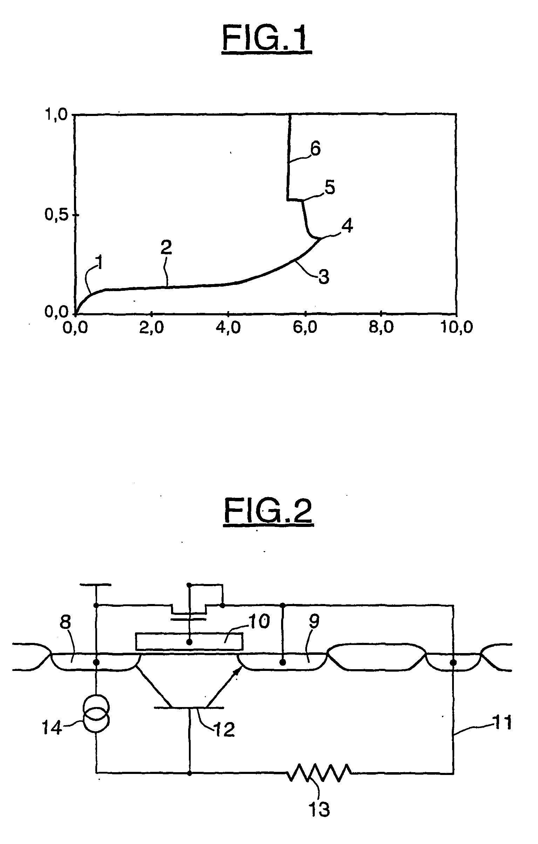

Comme on peut le voir sur la figure 1, où la tension de drain figure en abscisse et le courant de drain en ordonnée, un transistor NMOS possède quatre régions de fonctionnement. La région 1 est celle du fonctionnement linéaire classique d'un transistor MOS. La région 2 est celle du fonctionnement en régime saturé où le courant n'évolue que très faiblement en fonction de la tension. La région 3 est dite "d'avalanche" avec un affaiblissement de la jonction drain/substrat causé par l'avalanche de ladite jonction. Enfin, la région 4 est celle de la mise en conduction du transistor bipolaire parasite avec sur la courbe une première brisure référencée 5 et qui est réversible et une seconde brisure référencée 6 et qui est destructive donc irréversible.

Au-delà de la seconde brisure 6, on remarque que le courant évolue extrêmement rapidement en fonction de la tension, la pente de la courbe étant quasiment verticale. Le processus de brisure également appelé "second breakdown " étant irréversible, on peut se déplacer sur la courbe en partant de la seconde brisure 6 et en se déplaçant vers le haut, ce qui se traduit par une diminution de la résistance que présente le transistor MOS ainsi claqué dans la mesure où pour une tension de drain sensiblement constante, on voit que le courant augmente.

Sur la figure 2, est représentée la structure des différents constituants. Le transistor MOS comprend un drain 8, une source 9 et une grille 10 formés sur une base 11 également appelée bulk. Dans la base 11, se forme un transistor bipolaire parasite 12 dont le collecteur est formé par le drain 8, dont l'émetteur est formé par la source 9 et dont la base peut être modélisée comme étant reliée à la masse par une résistance de substrat 13 et par une source de courant 14 reliée au drain 8.

Dans le montage conforme à l'invention, le drain 8 est relié à une première tension d'alimentation, tandis que la source 9, la grille 10 et la base 11 sont court-circuitées et reliées à une deuxième tension d'alimentation. A partir du régime de saturation du transistor MOS, une tension élevée sur le drain déclenche l'avalanche de la jonction drain/ base par génération de paires électrons-trous, créant ainsi un courant de base. La tension aux bornes de la résistance de base augmente, polarisant ainsi la jonction source/base. Le transistor bipolaire parasite est ainsi amorcé, le phénomène de brisure se produit alors.

A fort courant, le composant rentre en régime de seconde brisure irréversible et qui se traduit par une destruction du réseau cristallin de polysilicium du canal formé entre le drain et la source. Après l'avalanche de la jonction collecteur-base du transistor bipolaire parasite, l'émetteur relié à la masse permet de mettre en direct la jonction base-émetteur, ce qui engendre l'effet de retournement ou snap-back. Pour déclencher le phénomène d'avalanche, il faut imposer une tension sur le drain suffisante pour mettre en inverse la jonction drain/base. Cette tension dépend des caractéristiques de dopage et est proportionnelle au carré du champ électrique.

Le générateur de courant 14 que l'on a représenté sur la figure 2 entre le collecteur et la base du transistor bipolaire parasite simule dans un premier temps les courants de fuite de la jonction drain/base. Par la suite, il permet de simuler l'avalanche de la jonction et la polarisation du transistor bipolaire parasite de type NPN.

A titre d'exemple, des essais ont été réalisés en technologie HF4 CMOS avec un transistor NMOS dont le canal est à dimensions suivantes : largeur (W) =1 µm, longueur du canal (L) = 0,7 µm. La source est à la masse et une rampe de tension évoluant de 8 à 18 volts avec une limitation en courant est appliquée sur le drain. Pour un courant de 2 mA, une résistance après claquage de 300 Ohms se forme. Pour un courant de 10 mA, on a obtenu une résistance après claquage de 60 Ohms et pour un courant de 100 mA, on a obtenu une résistance après claquage de 11 Ohms. On remarque que pour une tension de drain inférieure à 11 volts, la jonction drain/base n'est pas en avalanche, donc aucun courant ne passe à travers le canal drain/source. Au-delà de cette tension, le phénomène s'enclenche avec création d'un chemin conducteur permettant le passage du courant. Arrivé à la tension de claquage, tout le courant disponible passe dans le canal et une résistance se crée.

Il est particulièrement intéressant d'utiliser des transistors dont le canal est le plus court possible, dans la mesure où plus le canal est court, plus la tension de claquage est faible, en raison de l'augmentation du courant de drain et de l'augmentation du nombre de paires électrons-trous générées, à largeur de canal constante. Une diminution de la largeur de canal se traduit par une diminution de la tension et du courant de la seconde brisure 6 illustrée sur la figure 1. Même si la largeur du canal n'intervient pas dans la tension de la première brisure 5, une largeur réduite augmentera l'effet thermique de la seconde brisure 6 puisque les lignes de champ sont alors plus unidirectionnelles, impliquant une diminution du couple de la seconde brisure. Il est donc particulièrement intéressant d'utiliser des transistors MOS de faibles dimensions.

Lors de l'utilisation d'un transistor MOS en snap-back, le substrat est connecté au potentiel le plus bas du circuit pour polariser en inverse toutes les diodes parasites existant entre le drain 8 et la source 9 d'une part, et la base 11 d'autre part. La source 9 et la base 11 sont court-circuitées. On court-circuite également la grille 10 à la source 9 et à la base pour désactiver le transistor.

Avec ce type de transistor MOS snap-back, on peut ajuster des résistances disposées en parallèle, voir à ce sujet le document FR A 2 795 557.

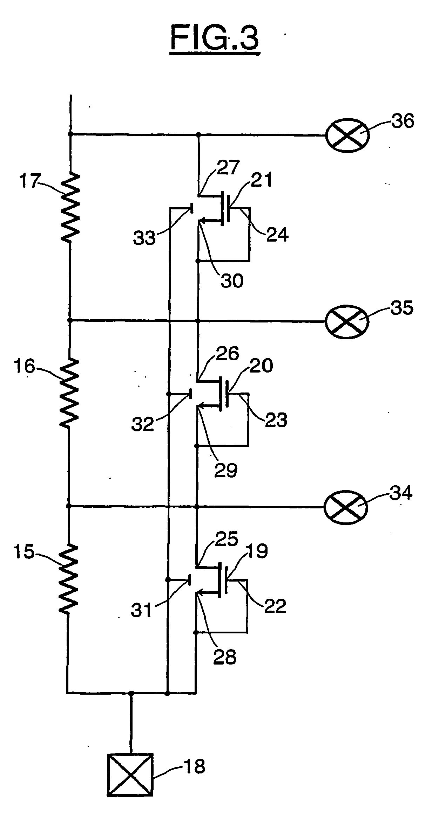

Sur la figure 3, est représenté un mode de réalisation de l'invention comprenant trois résistances à ajuster disposées en série référencées 15, 16 et 17, la résistance 15 étant reliée à un plot de masse 18 qui sera relié à une des broches externes du circuit lors de l'encapsulation et la résistance 17 étant reliée au reste du circuit, non représenté. Le dispositif comprend en outre trois transistors MOS 19, 20, 21 chacun pourvu d'une grille, respectivement 22, 23 et 24, d'un drain, respectivement 25, 26 et 27, d'une source et, respectivement 28, 29 et 30 et d'une base, respectivement 31, 32 et 33.

Le transistor 19 est monté parallèlement à la résistance 15, le transistor 20 parallèlement à la résistance 16 et le transistor 21 parallèlement à la résistance 17. La grille et la source de chaque transistor 19,20 et 21 sont court-circuitées. Les bases 31 à 33 des transistors 19 à 21 sont toutes reliées au plot 18. La grille 22 et la source 28 du transistor 19 sont reliées au plot 18. Le drain 25 du transistor 19, la grille 23 et la source 29 du transistor 20 sont reliés au point commun entre les résistance 15 et 16 et à un plot d'ajustement 34 qui pourra ne plus être accessible après l'encapsulation du circuit. Le drain 26 du transistor 20, la grille 24 et la source 30 du transistor 21 sont reliés au point commun entre les résistances 16 et 17 et à un plot 35 d'ajustement qui pourra ne plus être accessible après l'encapsulation du circuit. Le drain 27 du transistor 21 est relié à l'autre borne de la résistance 17, au reste du circuit, non représenté et à un plot d'ajustement 36 qui pourra ne plus être accessible après l'encapsulation du circuit.

Pour claquer le transistor 21, on connecte ensemble les plots 18 et 35 à la masse et on applique une rampe de tension positive sur le plot 36. Si on laissait le plot 18 non connecté, le phénomène de snap-back ne se produirait pas en raison de l'impossibilité d'avoir l'avalanche de la jonction drain/base et donc d'obtenir la polarisation en direct de la jonction base/émetteur.

Si l'on veut claquer le transistor 20, on connecte ensemble les plots 18 et 34 et on applique une rampe de tension positive sur le plot 35.

Pour claquer le transistor 19, on applique une rampe de tension positive sur le plot 34 et on connecte le plot 18 à la masse.

On peut ainsi ajuster de façon reproductible et fiable un système de résistances en série de faible valeur grâce aux transistors MOS. Un transistor MOS non isolé occupe une surface beaucoup plus faible que celle occupée par un transistor MOS isolé, par exemple une surface de 7 µm sur 14 µm au lieu d'une surface de 40 µm sur 40 µm soit une division par 16 environ de la surface de silicium occupée.

Le claquage des transistors MOS snap-back isolés est difficile à réaliser en raison de la présence d'un deuxième transistor bipolaire parasite dont le collecteur est formé par le drain du transistor MOS, l'émetteur par la source et la base par le bulk. Ce deuxième transistor parasite étant susceptible de dérober la majorité du courant que l'on envoie par un plot de claquage vers le drain du transistor MOS. Il en résulte que la résistance après claquage est susceptible de varier entre 100 Ohms et 1 k Ohms qui est à comparer à la résistance de 10 Ohms obtenue de façon reproductible lorsqu'on casse la structure MOS non isolée.

On entend ici par transistor MOS isolé un transistor MOS dont le substrat et la base sont séparés par une couche diélectrique. Les contraintes d'isolation verticale et surtout latérale poussent à utiliser des surfaces de silicium élevées pour augmenter les dimensions de la base et diminuer le gain du second transistor bipolaire parasite.

Sans exclure les transistors MOS isolés, on préfère plutôt utiliser des transistors MOS non isolés qui évitent la circulation de courants de fuite de la base vers le substrat. La base et le substrat sont au même potentiel. En outre, il est particulièrement avantageux de disposer la prise de base le plus près possible du drain pour des raisons de répartition des lignes de courant lors du claquage. La couche de base, de type P pour un transistor NMOS, peut être de forme annulaire ou non. Dans les deux cas, on disposera la prise de base, c'est à dire la sortie vers les niveaux de connexion, plus près du drain que de la source.

L'invention permet donc d'ajuster de façon précise et reproductible des résistances disposées en série et ce au moyen de transistors MOS économiques occupant une surface de silicium raisonnable.

## Revendications

1. Circuit électronique intégré comprenant une pluralité de transistors MOS, avec au moins un premier (19) et un deuxième (20) transistors MOS disposés en série, chaque transistor comprenant une grille et une source court-circuitées, et une base reliée à la masse du circuit intégré, **caractérisé par le fait qu'**il comprend une première résistante (15) montée parallèlement au premier transistor et une deuxième résistance (16) montée parallèlement au deuxième transistor.

2. Circuit selon la revendication 1, **caractérisé par le fait qu'**il comprend un troisième transistor (21) monté en série avec le premier et le deuxième transistors, et comprenant une grille et une source court circuitées, et une jonction de base reliée à la masse du circuit intégré.

3. Circuit selon la revendication 2, **caractérisé par le fait qu'**il comprend une troisième résistance (17) montée parallèlement au troisième transistor.

4. Circuit selon l'une quelconque des revendications précédentes, **caractérisé par le fait qu'**il comprend un plot de connexion (18) relié à la source du premier transistor et accessible après l'encapsulation du circuit.

5. Circuit selon l'une quelconque des revendications précédentes, **caractérisé par le fait qu'**il comprend un plot de connexion (34) relié à la source du deuxième transistor et non accessible après l'encapsulation du circuit et un plot de connexion (35) relié au drain du deuxième transistor et non-accessible après l'encapsulation du circuit.

6. Circuit selon l'une quelconque des revendications précédentes, **caractérisé par le fait que** chaque transistor MOS occupe une surface inférieure à 500 µm2, préférablement inférieure à 200 µm2.

7. Procédé d'ajustement de résistances électriques dans un circuit électronique intégré comprenant une pluralité de transistors MOS montés en série et chacun pourvu d'une résistance montée en parallèle, dans lequel on relie les bases des transistors MOS et on applique à un transistor MOS une première tension sur sa base, sa grille et sa source et une deuxième tension sur son drain afin de claquer ledit transistor MOS.

8. Procédé selon la revendication 7, dans lequel la première tension est constante et la deuxième tension est une rampe monotone.

9. Procédé selon la revendication 8, dans lequel la première tension est nulle et la deuxième tension est croissante.

## Claims

1. Integrated electronic circuit including a plurality of MOS transistors, at least one first MOS transistor (19) and one second MOS transistor (20) being connected in series, each transistor having a gate and a source which are short-circuited and a base connected to the ground of the integrated circuit, **characterized in that** it includes a first resistance (15) connected in parallel with the first transistor and a second resistance (16) connected in parallel with the second transistor.

2. Circuit according to Claim 1, **characterized in that** it includes a third transistor (21) connected in series with the first and second transistors and having a gate and a source which are short-circuited and a base junction which is connected to the ground of the integrated circuit.

3. Circuit according to Claim 2, **characterized in that** it includes a third resistance (17) connected in parallel with the third transistor.

4. Circuit according to any preceding claim, **characterized in that** it includes a connecting terminal (18) which is connected to the source of the first transistor and is accessible after encapsulating the circuit.

5. Circuit according to any preceding claim, **characterized in that** it includes a connecting terminal (34) which is connected to the source of the second transistor and is not accessible after encapsulating the circuit and a connecting terminal (35) which is connected to the drain of the second transistor and is not accessible after encapsulating the circuit.

6. Circuit according to any preceding claim, **characterized in that** each MOS transistor occupies an area less than 500 µm², and preferably less than 200 µm².

7. Method of adjusting electrical resistances in an integrated electronic circuit including a plurality of MOS transistors connected in series and each having a resistance connected in parallel with it, in which method the bases of the MOS transistors are connected together and a first voltage is applied to the base, the gate and the source of an MOS transistor and a second voltage is applied to its drain in order to cause breakdown of said MOS transistor.

8. Method according to Claim 7, in which the first voltage is constant and the second voltage is a monotonous ramp.

9. Method according to Claim 8, in which the first voltage is zero and the second voltage increases.

## Patentansprüche

1. Integrierte elektronische Schaltung, die eine Vielzahl von MOS-Transistoren enthält, mit mindestens einem ersten (19) und einem zweiten (20) MOS-Transistor in Reihe geschaltet, wobei jeder Transistor ein Gate und eine Source, die kurzgeschlossen sind, und eine Basis enthält, die mit der Masse der integrierten Schaltung verbunden sind, **dadurch gekennzeichnet, dass** sie einen ersten Widerstand (15), der mit dem ersten Transistor parallelgeschaltet ist, und einen zweiten Widerstand (16) enthält, der mit dem zweiten Transistor parallelgeschaltet ist.

2. Schaltung nach Anspruch 1, **dadurch gekennzeichnet, dass** sie einen dritten Transistor (21) enthält, der mit dem ersten und dem zweiten Transistor in Reihe geschaltet ist und ein Gate und eine Source, die kurzgeschlossen sind, und einen Basisübergang enthält, der mit der Masse der integrierten Schaltung verbunden ist.

3. Schaltung nach Anspruch 2, **dadurch gekennzeichnet, dass** sie einen dritten Widerstand (17) enthält, der mit dem dritten Transistor parallelgeschaltet ist.

4. Schaltung nach einem der vorhergehenden Ansprüche, **dadurch gekennzeichnet, dass** sie einen Anschlusskontakt (18) enthält, der mit der Source des ersten Transistors verbunden und nach Einkapselung der Schaltung zugänglich ist.

5. Schaltung nach einem der vorhergehenden Ansprüche, **dadurch gekennzeichnet, dass** sie einen Anschlusskontakt (34), der mit der Source des zweiten Transistors verbunden und nach der Einkapselung der Schaltung nicht zugänglich ist, und einen Anschlusskontakt (35) enthält, der mit dem Drain des zweiten Transistors verbunden und nach der Einkapselung der Schaltung nicht zugänglich ist.

6. Schaltung nach einem der vorhergehenden Ansprüche, **dadurch gekennzeichnet, dass** jeder MOS-Transistor eine Fläche von weniger als 500 µm2, vorzugsweise weniger als 200 µm2, einnimmt.

7. Verfahren zum Justieren von elektrischen Widerständen in einer integrierten elektronischen Schaltung, die eine Vielzahl von MOS-Transistoren enthält, die in Reihe geschaltet und jeder mit einem parallelgeschalteten Widerstand versehen sind, bei dem die Basen der MOS-Transistoren verbunden werden und an einen MOS-Transistor eine erste Spannung an seiner Basis, seinem Gate und seiner Source und eine zweite Spannung an seinem Drain angelegt wird, um den MOS-Transistor durchschlagen zu lassen.

8. Verfahren nach Anspruch 7, bei dem die erste Spannung konstant und die zweite Spannung eine monotone Rampe ist.

9. Verfahren nach Anspruch 8, bei dem die erste Spannung Null und die zweite Spannung ansteigend ist.
